# EUROPEAN PATENT SPECIFICATION

(11) **EP 1 619 700 B1**
(45) Date of publication and mention of the grant of the patent: **07.03.2007**
(21) Application number: 05015448.3
(22) Date of filing: 15.07.2005
(51) Int. Cl.: H01G 9/20

(54) **Photoactive layer containing macroparticles and nanoparticles**
Photoaktive Schicht mit Makropartikeln und Nanopartikeln
Couche photoactive contenant des macroparticules et des nanoparticules

(30) Priority: 20.07.2004 US 589423 P
(43) Date of publication of application: 25.01.2006
(73) Proprietor: Konarka Technologies, Inc., Lowell, MA 01852 (US)
(72) Inventor: Brooks, Keith, 1110 Morges (CH); Balasubramanian, Srini, Westford MA 01886 (US); Cardone, John, W. Peabody MA 01960 (US)
(74) Representative: Altenburg, Udo

(56) References cited:
- EP-A- 1 542 249
- WO-A-94/00887
- US-A- 5 441 827

## Description

### TECHICAL FIELD

The invention relates to photoactive layers that contain macroparticles, as well as related photovoltaic cells, systems and methods.

### BACKGROUND

Photovoltaic cells, sometimes called solar cells, can convert light, such as sunlight, into electrical energy. One type of photovoltaic cell is a dye-sensitized solar cell (DSSC).

Document WO-A-94 0̸0̸ 887 discloses a cell with semiconductor nanocristalline having an average size of from about 3 to about 100 nm.

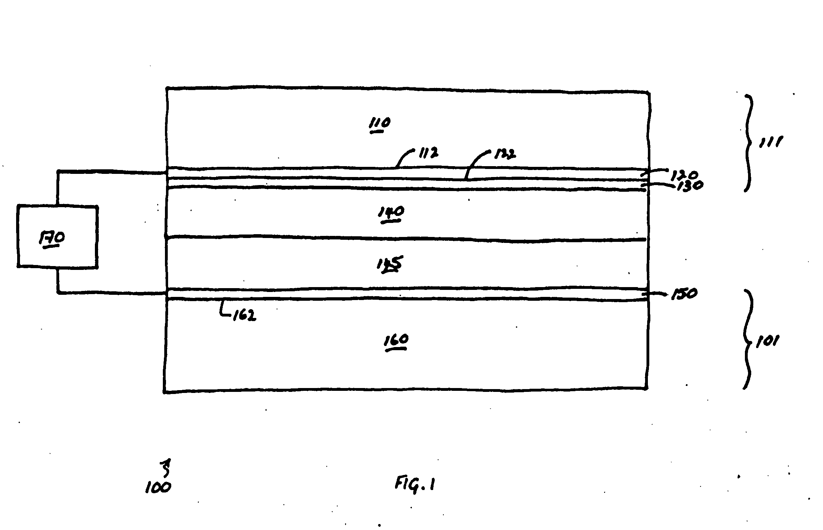

Referring to FIG. 1, is a DSSC 100 includes a charge carrier layer 140 (e.g., including an electrolyte, such as an iodide/iodine solution) and a photosensitized layer 145 (e.g., including a semiconductor material, such as TiO2 particles) disposed between an electrode 101 and a counter electrode 111. Photosensitized layer 145 also includes a photosensitizing agent, such as a dye. In general, the photosensitizing agent is capable of absorbing photons within a wavelength range of operation (e.g., within the solar spectrum). Electrode 101 includes a substrate 160 (e.g., a glass, a metal or a polymer substrate) and an electrically conductive layer 150 (e.g., an ITO layer or tin oxide layer) disposed on an inner surface 162 of substrate 160. Counter electrode 111 includes a substrate 110, an electrically conductive layer 120 (e.g., ITO layer or tin oxide layer), and a platinum, PEDOT or carbon layer 130, which catalyzes a redox reaction in charge carrier layer 140. Electrically conductive layer 120 is disposed on an inner surface 112 of substrate 110, while catalyst layer 130 is disposed on a surface 122 of electrically conductive layer 120. Electrode 101 and counter electrode 111 are connected by wires across an external electrical load 170.

During operation, in response to illumination by radiation in the solar spectrum, DSSC 100 undergoes cycles of excitation, oxidation, and reduction that produce a flow of electrons across load 170. Incident light excites photosensitizing agent molecules in photosensitized layer 145. The photoexcited photosensitizing agent molecules then inject electrons into the conduction band of the semiconductor in layer 145, which leaves the photosensitizing agent molecules oxidized. The injected electrons flow through the semiconductor material, to electrically conductive layer 150, then to external load 170. After flowing through external load 170, the electrons flow to layer 120, then to layer 130 and subsequently to layer 140, where the electrons reduce the electrolyte material in charge carrier layer 140 at catalyst layer 130. The reduced electrolyte can then reduce the oxidized photosensitizing agent molecules back to their neutral state. The electrolyte in layer 140 can act as a redox mediator to control the flow of electrons from counter electrode 111 to working electrode 101. This cycle of excitation, oxidation, and reduction is repeated to provide continuous electrical energy to external load 170.

### SUMMARY

The invention relates to photoactive layers that contain macroparticles, as well as related photovoltaic cells, systems and methods.

In one aspect, the invention relates a composition as defined in claim 1 that includes macroparticles of a first semiconductor material and nanoparticles of a second semiconductor material. The macroparticles have an average particle size of at least about 100 nanometers, and the nanoparticles having an average size of at most about 50 nanometers. At least some of the nanoparticles and macroparticles are chemically bonded to each other.

The first and second semiconductor materials can be the same or different.

In some embodiments, the first and/or second semiconductor material can have the formula MₓO_{y}, where x is greater than zero, y is greater than zero, and M is titanium, zirconium, zinc, tungsten, niobium, lanthanum, tantalum, terbium and/or tin.

The composition can further include, for example, a photosensitizing agent. Examples of photosensitizing agents include anthocyanines, porphyrins, phthalocyanines, merocyanines, cyanines, squarates, eosins, and metal-containing dyes.

The composition can be, for example, a photoactive layer capable of being used in a photovoltaic cell.

In some embodiments, less than about 25% of a total surface area of the macroparticles is exposed.

In certain embodiments, at least about 70% of a total surface area of the macroparticles has nanoparticles chemically bonded thereto.

In another aspect, the invention features a photovoltaic cell that includes two electrodes and a photoactive layer between the electrodes. The photoactive layer is formed with a composition that includes macroparticles of a first semiconductor material and nanoparticles of a second semiconductor material. The macroparticles have an average particle size of at least about 100 nanometers, and the nanoparticles having an average size of at most about 50 nanometers. At least some of the nanoparticles and macroparticles are chemically bonded to each other.

In a further aspect, the invention features a method as defined in claim 19 that includes: forming a first mixture comprising a precursor of semiconductor nanoparticles; forming a second mixture comprising semiconductor macroparticles having an average particles size of at least about 100 nanometers; and combining the first and second mixtures.

The method can further include, for example, reacting the precursor and semiconductor nanoparticles. In some embodiments, reacting includes, after combining the first and second mixtures, heating the precursor and semiconductor particles. The method can also include, for example, before heating the precursor and semiconductor particles, adding an acid to the precursor and semiconductor particle to form a third mixture. Examples of acids include nitric acid, sulfuric acid and hydrochloric acid. The method can further include, for example, after adding the acid, heating the third mixture to a first temperature. The first temperature can be, for example, at most about 100°C. The method can also include, for example: holding the third mixture at the first temperature for a period of time; and then, heating the third mixture to a second temperature higher than the first temperature. The second temperature can be, for example, at least about 200°C.

In an additional aspect, the invention features a method as defined in claim 29 that includes: combining a precursor of semiconductor nanoparticles and semiconductor macroparticles; and reacting the precursor and macroparticles. The macroparticles can have an average particles size of at least about 100 nanometers.

Reacting the precursor and macroparticles can form, for example, a composition that include semiconductor nanoparticles and semiconductor macroparticles. At least some of the nanoparticles and macroparticles are chemically bonded to each other, and the semiconductor nanoparticles can have an average particle size of at most about 50 nanometers. The method can further include, for example, treating the composition with a photosensitizing agent to form a photoactive layer. The method can also include, for example, incorporating the photoactive layer into a photovoltaic cell.

Embodiments can provide one or more of the following advantages.

In some embodiments, the semiconductor material can be used in the photoactive layer of a photovoltaic cell to provide a photovoltaic cell having relatively high efficiency, relatively high voltage (open circuit), relatively high J_{sc}, and/or relatively high fill factor.

In certain embodiments, the semiconductor material can exhibit enhanced light scattering and/or reduced electrical impedance.

Features and advantages of the invention are in the description, drawings and claims.

### DESCRIPTION OF DRAWINGS

FIG. 1 is a cross-sectional view of an embodiment of a photovoltaic cell;
FIG. 2 is a cross-sectional view of an embodiment of a photovoltaic cell;
FIG. 3 is a scanning electron micrograph of a semiconductor material including semiconductor nanoparticles and semiconductor macroparticles; and
FIG. 4 is a scanning electron micrograph of a semiconductor material including semiconductor nanoparticles and semiconductor macroparticles.

Like reference symbols in the various drawings indicate like elements.

### DETAILED DESCRIPTION

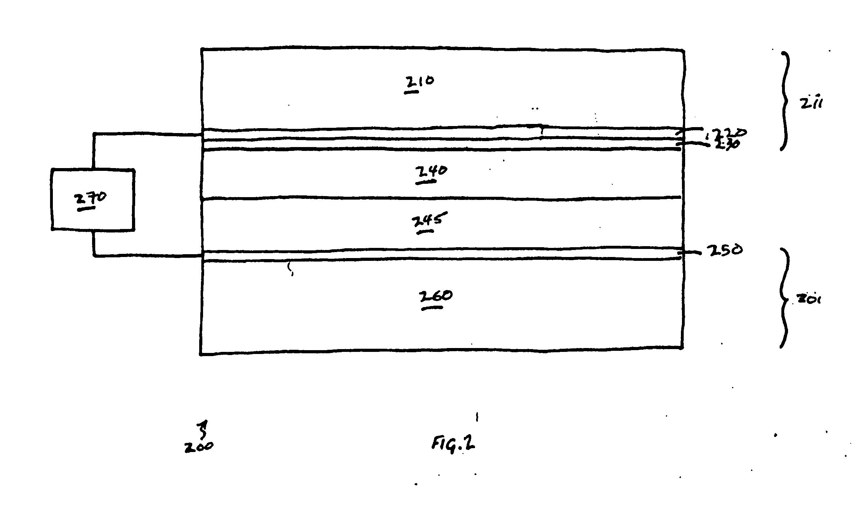

Fig. 2 shows a DSSC 200 that includes an electrode 201 and a counterelectrode 211 that are electrically connected to an external load 270. Electrode 201 includes a substrate 260 and an electrically conductive layer 250. Counterelectrode 211 includes a substrate 210, an electrically conductive layer 220 and a catalyst layer 230. DSSC 200 also includes a charge carrier layer 240 and a photoactive layer 245 disposed between electrode 201 and counterelectrode 211.

Photoactive layer 245 includes a semiconductor material formed of macroparticles of the semiconductor material and nanoparticles of the semiconductor material. At least some of the semiconductor macroparticles are chemically bonded to each other, and at least some of the semiconductor nanoparticles are bonded to semiconductor macroparticles. Photoactive layer 245 further includes a photosensitizing agent sorbed (e.g., chemisorbed and/or physisorbed) on the semiconductor material.

The term macroparticles, as used herein, refers to a collection of particles having an average particle size of at least about 100 nanometers (e.g., at least about 150 nanometers, at least about 200 nanometers, at least about 250 nanometers). In certain embodiments, macroparticles can have an average particle size of at most about 750 nanometers (e.g., at most about 600 nanometers, at most about 500 nanometers, at most about 400 nanometers, at most about 300 nanometers). For example, in certain embodiments, macroparticles can have an average particle size of from about 100 nanometers to about 500 nanometers (e.g., from about 200 nanometers to about 400 nanometers, from about 200 nanometers to about 300 nanometers).

The term nanoparticles, as used herein, refers to a collection of particles having an average particle size of at most about 50 nanometers (e.g., at most about 40 nanometers, at most about 30 nanometers, at most about 25 nanometers, at most about 20 nanometers, at most about 15 nanometers). In some embodiments, nanoparticles can have an average particle size of at least about one nanometer (e.g., at least about two nanometers, at least about five nanometers, at least about 10 nanometers, at least about 15 nanometers) and/or. For example, in certain embodiments, the nanoparticles have an average particle size of from about two nanometers to about 30 nanometers (e.g., from about five nanometers to about 25 nanometers, from about 15 nanometers to about 20 nanometers). The average particle size of the nanoparticles in photoactive layer 245 is measured using a transmission electron microscope.

In some embodiments, at least about 70% (e.g., at least about 80%, at least about 90%, at least about 95%, about 100%) of the total surface area of the macroparticles in layer 245 has nanoparticles chemically bonded thereto.

In certain embodiments, less than about 25% (e.g., less than about 20%, less than about 15%, less than about 10%) of the total surface area of the macroparticles in layer 245 is exposed.

Without wishing to be bound by theory, it is believed that photoactive layer 245 can exhibit relatively high light scattering because, for example, the effective size of the scattering particles is increased by bonding colloidal particles on the surface. It is further believed that photoactive layer 245 can exhibit relatively low electrical impedance because, for example, by chemically bonding at least some of the macroparticles with other macroparticles and by chemically bonding at least some of the nanoparticles to macroparticles, the semiconductor material provides extended networks of electrically connected particles.

Examples of semiconductor materials from which the macroparticles and nanoparticles can be formed can have the formula MₓO_{y}, where M may be, for example, titanium, zirconium, zinc, tungsten, niobium, lanthanum, tantalum, terbium, or tin and x is greater than zero (e.g., an integer greater than zero) and y is greater than zero (e.g., an integer greater than zero). Additional examples of semiconductor materials from which the macroparticles and nanoparticles can be formed include sulfides, selenides, tellurides, and oxides of titanium, zirconium, niobium, lanthanum, tantalum, terbium, tin or combinations thereof. For example, TiO₂, SrTiO₃, CaTiO₃, ZrO₂, WO₃, La₂O₃, Nb₂O₅, SnO₂, sodium titanate, cadmium selenide (CdSe), cadmium sulphides, and potassium niobate may be suitable macroparticle materials and nanoparticle materials.

In general, the photosensitizing agent facilitates conversion of incident light into electricity to produce the desired photovoltaic effect. It is believed that the photosensitizing agent absorbs incident light resulting in the excitation of electrons in the photosensitizing agent. The energy of the excited electrons is then transferred from the excitation levels of the photosensitizing agent into the conduction band of the semiconductor material. This electron transfer results in an effective separation of charge and the desired photovoltaic effect.

The photosensitizing agent is selected, for example, based on its ability to inject electrons into the conduction band of the semiconductor material, and its effectiveness in complexing with or sorbing to the semiconductor material. Examples of photosensitizing agents include, for example, dyes that include functional groups, such as carboxyl and/or hydroxyl groups, that can chelate to the semiconductor material (e.g., to Ti(TV) sites on a TiO₂ surface). Exemplary dyes include anthocyanines, porphyrins, phthalocyanines, merocyanines, cyanines, squarates, eosins, and metal-containing dyes such as cis-bis(isothiocyanato)bis(2,2' - bipyridyl-4,4'-25 dicarboxylato)-ruthenium (II) ('N3 dye"), tris(isothiocyanato)-ruthenium(II)-2,2':6',2"-terpyridene-4,4',4"-tricarboxylic acid, cis-bis(isothiocyanato)bis(2,2'-bipyridyl-4,4'-dicarboxylato) ruthenium (II) bis-tetrabutylammonium, cis-bis(isocyanato) (2,2'-bipyridyl-4,4' dicarboxylato) ruthenium (II) and tris(2,2'-bipyridyl-4,4'-dicarboxylato) ruthenium (II) dichloride.

In general, photoactive material 245 can be prepared as desired.

Typically, the method includes forming a first mixture by mixing a precursor of the semiconductor nanoparticles with an acid or a base or at neutral pH. In general, the precursor can be any material that is capable of being processed with the acid to form nanoparticles of the semiconductor material. Examples of precursors include Ti(IV) isopropoxide, Ti(IV) ethoxide, Ti(IV) butoxide, TiCl₄. The acid can be any acid that can react with the precursor and modify its hydrolysis rate. Examples of acids include acetic acid and nitric acid. Mixing the precursor with the acid can cause an exothermic reaction to occur. Accordingly, the mixing temperature is usually about room temperature or less (e.g., from about 0°C to room temperature).

A second mixture is formed by dispersing the semiconductor macroparticles in an appropriate liquid (e.g., water). The dispersion can be generally be formed at any desired temperature (e.g., about room temperature).

The first and second mixtures are combined to form a third mixture. In general, the mixtures are combined at any desired temperature (e.g., about room temperature).

The third mixture is then heated and an acid is added. In general, the acid is capable of aiding in the hydrolysis of the precursor and condensation of the hydrolyzed precursor to form TiO₂. Examples of acids include nitric acid, sulfuric acid and hydrochloric acid. In general, the temperature used when adding the acid is elevated (e.g., about 80°C) to accelerate the hydrolysis of the precursor. In some embodiments, the temperature used is from about 25°C to about 100°C (e.g., from about 70°C to about 90°C, such as about 80°C).

After adding the acid and stirring the mixture (e.g., at about 80°C for about two hours), the mixture is heated (e.g., autoclaved in a titanium autoclave) at a temperature and for a period of time sufficient to form the semiconductor material described above. Generally, the temperature is from about 200°C to about 250°C (e.g., from about 220°C to about 250°C, such as about 230°C). In general, the time is from about 10 hours to about 14 hours (e.g., from about 11 hours to about 13 hours, such as about 12 hours). The pressure is generally selected as appropriate. Typically, the pressure is from about 400 pounds per square inch (psi) (e.g. 2,75 MPa) to about 900 psi (e.g. 6,20 MPa (e.g., about 700 psi (e.g. 4,83 MPa)).

Turning now to the other components of DSSC 200, charge carrier layer 240 can include a material that facilitates the transfer of electrical charge from a ground potential or a current source to photoactive layer 245. General classes of suitable charge carrier materials include solvent-based liquid electrolytes, polyelectrolytes, polymeric electrolytes, solid electrolytes, n-type and p-type transporting materials (e.g., conducting polymers) and gel electrolytes. Other choices for charge carrier media are possible. For example, charge carrier layer 240 can include a lithium salt that has the formula LiX, where X is an iodide, bromide, chloride, perchlorate, thiocyanate, trifluoromethyl sulfonate, or hexafluorophosphate.

Charge carrier layer 240 typically includes a redox system. Suitable redox systems can include organic and/or inorganic redox systems. Examples of such systems include cerium(III) sulphate/cerium(IV), sodium bromide/bromine, lithium iodide/iodine, Fe²⁺/Fe³⁺, Co²⁺/Co³⁺, and viologens. Furthermore, an electrolyte solution may have the formula MᵢXⱼ, where i and j are greater than or equal to one, where X is an anion, and M may be, for example, imidazolium, lithium, copper, barium, zinc, nickel, a lanthanide, cobalt, calcium, aluminum, or magnesium. Suitable anions include chloride, perchlorate, thiocyanate, trifluoromethyl sulfonate, and hexafluorophosphate.

In some embodiments, the charge carrier media can include a polymeric electrolyte. For example, the polymeric electrolyte can include poly(vinyl imidazolium halide) and lithium iodide and/or polyvinyl pyridinium salts. The charge carrier media can include a solid electrolyte, such as, lithium iodide, pyridinium iodide, and/or substituted imidazolium iodide.

In certain embodiments, the charge carrier media includes various types of polymeric polyelectrolytes. For example, suitable polyelectrolytes can include between about 5% and about 95% (e.g., 5-60%, 5-40%, or 5-20%) by weight of a plasticizer, about 0.05 M to about 10 M of a redox electrolyte of organic or inorganic iodides (e.g., about 0.05 to 2 M, 0.05 to 1 M, or 0.05 to 0.5 M), and about 0.01 M to about 1 M (e.g., about 0.05 to 0.5 M, 0.05 M to 0.2M, or 0.05 to 0.1 M) of iodine. The ion-conducting polymer may include, for example, polyethylene oxide (PEO), polyacrylonitrile (PAN), polymethylmethacrylate (PMMA), polyethers, polyphenols, or copolymers thereof. Examples of suitable plasticizers include ethyl carbonate, propylene carbonate, mixtures of carbonates, organic phosphates, butyrolactone, and dialkylphthalates.

Generally, conductive layer 250 is formed from a layer of a material having an electrical conductivity of at least about 10 (Ω-cm)⁻¹ at 25°C, and can have a composition and thickness that can be selected based on electrical conductivity, optical properties, and/or mechanical properties as desired. In some embodiments, the layer 250 can be transparent. Examples of transparent conductors include certain metal oxides, such as indium tin oxide (TTO), tin oxide, a fluorine-doped tin oxide, and zinc-oxide. In certain embodiments, layer 250 can be non-transparent (e.g., substantially opaque). Examples of opaque conductors include a continuous layer (e.g., a foil) of a metal. In embodiments in which the photoactive material is a dye sensitized material (e.g., dye sensitized titania), the metal can be, for example, titanium. In embodiments in which the photoactive material is a heterojunction composite (e.g., conductive polymer and fullerene), the metal can be, for example, copper, aluminum, titanium, indium, or gold.

In certain embodiments, layer 250 includes a discontinuous layer of a conductive material. For example, layer 250 can include an electrically conducting mesh. Suitable mesh materials include metals, such as palladium, titanium, platinum, stainless steel and alloys thereof. The mesh material can include a metal wire. The electrically conductive mesh material can also include an electrically insulating material that has been coated with an electrically conductive material, such as metal. The electrically insulating material can include a fiber, such as a textile fiber or an optical fiber. Examples of textile fibers include synthetic polymer fibers (e.g., nylons) and natural fibers (e.g., flax, cotton, wool, and silk). The mesh electrode can be flexible to facilitate, for example, formation of a photovoltaic cell by a continuous manufacturing process.

A mesh electrode, can take a wide variety of forms with respect to, for example, wire (or fiber) diameters and mesh densities (i.e., the number of wire (or fiber) per unit area of the mesh). The mesh can be, for example, regular or irregular, with any number of opening shapes (e.g., square, circle, semicircle, triangular, diamond, ellipse, trapezoid, and/or irregular shapes). Mesh form factors (such as, e.g., wire diameter and mesh density) can be chosen, for example, based on the conductivity of the wire (or fibers) of the mesh, the desired optical transmissivity, based on the conductivity of the wires (or fibers) of the mesh, the desired optical transmissivity, flexibility, and/or mechanical strength. Typically, the mesh electrode includes a wire (or fiber) mesh with an average wire (or fiber) diameter in the range from about 1 micron to about 400 microns, and an average open area between wires (or fibers) in the range from about 60% to about 95%. A mesh electrode can be formed using a variety of techniques, such as, for example, ink jet printing, lithography and/or ablation (e.g., laser ablation). Mesh electrodes are discussed in U.S. Patent Application Serial No. 10/395,823, filed March 23, 2003 and in U.S. Patent Application Serial No. 10/723,554, filed November 26, 2003.

Generally, layer 220 is formed of a material having an electrical conductivity of at least about 10 (Ω-cm)⁻¹ at 25°C, and can have a composition and thickness that can be selected based on electrical conductivity, optical properties, and/or mechanical properties as desired. Layer 220 can be similar to layer 250. For example, layer 220 can be formed from the same materials (e.g., transparent conductor, opaque conductor), can have the same structure (e.g., continuous layer, mesh structure) and can have the same thickness as layer 250. However, it may be desirable for layer 220 to be different from layer 250 in one or more aspects. For example, in configurations where only one side of DSSC 200 (e.g., either the electrode side or the counterelectrode side) is exposed to a light source during use, the conductive layer (layer 250, layer 220) of the unexposed electrode (electrode 201, counterelectrode 211, respectively) may be formed of a nontransparent material (e.g., an opaque material).

Catalyst layer 230 is generally formed of a material that can catalyze a redox reaction in the charge carrier layer positioned below. Examples of materials from which catalyst layer can be formed include platinum and poly(3,4-ethylenedioxythiophene) (PEDOT). PEDOT layers are discussed in U.S. Provisional Patent Application Serial No. 60/495,302, filed on August 15, 2003. Materials can be selected based on criteria such as, e.g., their compatibility with manufacturing processes, long term stability, and optical properties. In general, the catalyst layer is substantially transparent. However, in certain embodiments, (e.g., embodiments in which the cathodes are substantially transparent) the catalyst layer can be substantially opaque.

In general, substrates 210 and 260 can be formed of a mechanically flexible material, such as a flexible polymer, or a rigid material, such as a glass. Examples of polymers that can be used to form a flexible substrate include polyethylene naphthalates (PEN), polyethylene terephthalates (PET), polyethyelenes, polypropylenes, polyamides, polymethylmethacrylate, polycarbonate, fluorocarbon polymers, and/or polyurethanes. Flexible substrates can facilitate continuous manufacturing processes such as web-based coating and lamination.

The thickness of substrates 210 and 260 can vary as desired. Typically, substrate thickness and type are selected to provide mechanical support sufficient for a photovoltaic cell to withstands the rigors of manufacturing, deployment and use. Substrates 210 and 260 can each have a thickness of about 20 microns to 5,000 microns, such as, for example about 100 microns to 1,000 microns.

In embodiments in which counterelectrode 211 is transparent, substrate 210 can be formed from a transparent material. Similarly, in embodiments in which electrode 201 is transparent, substrate 260 can be formed from a transparent material. Examples of suitable transparent materials include transparent glass or polymers, such as a silica-based glass or a polymer, such as those listed above.

Although, in the foregoing embodiments, the semiconductor material and electrolyte are in different layers, in some embodiments these materials may be interspersed in a composite layer.

While certain embodiments have been described, other embodiments are possible.

As an example, in certain embodiments, the nanoparticles in layer 245 can be formed of more than one semiconductor material and/or different nanoparticles in layer 245 can be formed of different semiconductor materials.

As another example, in certain embodiments, the macroparticles in layer 245 can be formed of more than one semiconductor material and/or different macroparticles in layer 245 can be formed of different semiconductor materials.

As a further example, in some embodiments, the nanoparticles in layer 245 are formed from a different semiconductor material than the macroparticles in layer 245.

As an additional example, in some embodiments, more than one nanoparticle precursor and/or more than one macroparticle material can be used.

As another example, while embodiments have been described in which, prior to being combined a mixture containing the macroparticles is formed separately from a mixture containing the nanoparticle precursor, in some embodiments, the macroparticles and nanoparticle precursor are combined in a single mixture without first forming separate mixtures.

As a further example, while embodiments have been described in which the mixture containing the macroparticles and nanoparticle precursor is heated prior to adding an acid, in certain embodiments, the mixture is heated after adding the acid.

The following examples are illustrative and not intended to be limiting.

### Example I

A composition containing a mixture of titania nanopailicles and titania macroparticles was prepared as follows. The nanoparticles were not chemically bonded to the macroparticles.

The titania nanoparticles were prepared without the addition of the macroparticles. A dispersion of the macroparticles in water was prepared at 50% solids. The nanoparticle dispersion and the macroparticle dispersion were physically mixed using a stirring bar and a polymer solution was added to aid in film formation. The mixture was coated, dried and sintered to obtain a TiO₂ film.

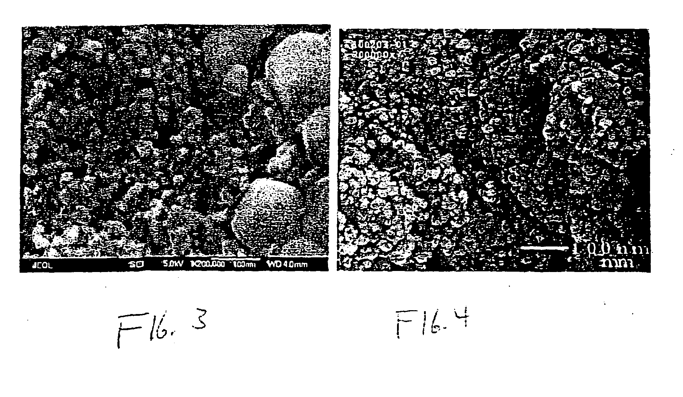

The SEM image (magnification of 200,000, taken with a commercial scanning electron micrograph) of the resulting material is shown in FIG. 3.

### Example II

A composition containing titania nanoparticles and titania macroparticles was prepared as follows.

216.17 grams of titanium (IV) isopropoxide (available from Aldrich Chemical Company, located in Milwaukee, Wisconsin) was mixed with 42.42 milliliters of glacial acetic acid (available from VWR Scientific, located in Pennsylvania) were mixed at 25°C.

20 grams of anatase titania particles having an average particle size of 200 nanometers (available from Huntsman TiOxide, located in Billingham, England) were mixed with 100 milliliters of water at 25°C.

These two mixtures were combined at 25°C, and then 19.92 milliliters of nitric acid was added (available from VWR Scientific, located in Pennsylvania). This mixture was heated to 230°C for 12 hours in a titanium autoclave. After autoclaving, the supernatant was decanted and 8.85 milliliters of nitric acid was added under agitation. The mixture was sonified to get a uniform dispersion.

The SEM image (magnification of 200,000, taken with a commercial scanning electron micrograph) of the resulting material is shown in FIG. 4.

### Example III

A photovoltaic cell was prepared as follows.

The sintered film from Example I was soaked in a dye solution (8 mM of ruthenium dye in N,N-dimethylformamide) at room temperature for five minutes, rinsed with ethanol and dried at 70°C for 10 minutes. The ruthenium dye had the chemical structure: 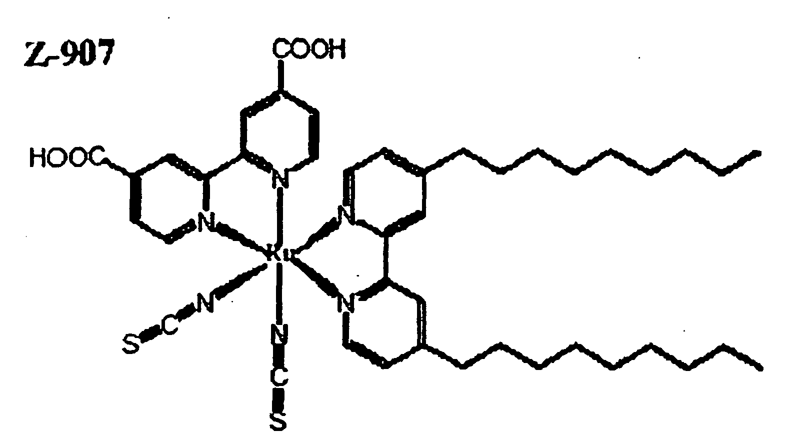 Electrolyte was spread on the dyed TiO₂ film and counter electrode was placed on the film. The two electrodes were held in place by adhesive strips.

The current-voltage characteristics (I-V) of the resulting cell was tested using a solar simulator. The resulting cell had a voltage (open current) of 0.67, a J_{sc} of 9.09 milliAmperes per square centimeter, an efficiency of 3.88%, and a fill factor of 64.4%.

### Example IV

A photovoltaic cell was prepared as follows.

The sintered film from Example II was soaked in a dye solution (8 mM of ruthenium dye having the structured disclosed in Example III in N,N-dimethylformamide) at room temperature for five minutes, rinsed with ethanol and dried at 70°C for 10 minutes. Electrolyte was spread on the dyed TiO₂ film and a counter electrode was placed on the film. The two electrodes were held in place by adhesive strips.

The resulting cell had a voltage (open circuit) of 0.68V, a J_{sc} of 10.18 milliAmperes per square centimeter, an efficiency of 4.34% and a fill factor of 63.1%.

### Example V

A photovoltaic cell was prepared as described in Example IV, except that 216.7 grams of the titanium (IV) isopropoxide was used, and 15 grams of the anatase titania particles were used so that, rather than a 75:25 ratio of nanoparticles to macroparticles, the ratio was 80:20.

The resulting cell had a voltage (open circuit) of 0.64V, a J_{sc} of 11.62 milliAmperes per square centimeter, an efficiency of 4.69% and a fill factor of 63.2%.

### Example VI

A photovoltaic cell was prepared as described in Example IV, except that 216.7 grams of the titanium (IV) isopropoxide was used, and 11.25 grams of the anatase titania particles were used so that, rather than a 75:25 ratio of nanoparticles to macroparticles, the ratio was 85:15.

The resulting cell had a voltage (open circuit) of 0.65V, a J_{sc} of 10.80 milliAmperes per square centimeter, an efficiency of 4.33% and a fill factor of 62.5%.

### Example VII

A photovoltaic cell was prepared as described in Example IV, except that 216.7 grams of the titanium (IV) isopropoxide was used, and 6.7 grams of the anatase titania particles were used so that, rather than a 75:25 ratio of nanoparticles to macroparticles, the ratio was 90:10.

The resulting cell had a voltage (open circuit) of 0.65V, a J_{sc} of 11.25 milliAmperes per square centimeter, an efficiency of 4.53% and a fill factor of 62.2%.

Other embodiments are in the claims.

## Claims

1. A composition for photoactive layers in photovoltaic cells, comprising:
macroparticles of a first semiconductor material, the macroparticles having an average particle size of at least about 100 nanometers; and
nanoparticles of a second semiconductor material, the nanoparticles having an average size of at most about 50 nanometers,
wherein at least some of the nanoparticles and macroparticles are chemically bonded to each other.

2. The composition of claim 1, wherein the first and second semiconductor materials are the same.

3. The composition of claim 2, wherein the first semiconductor material has the formula MₓO_{y}, where x is greater than zero, y is greater than zero, and M is selected from the group consisting of titanium, zirconium, zinc, tungsten, niobium, lanthanum, tantalum, terbium and tin.

4. The composition of claim 3, wherein the first semiconductor material comprises titania.

5. The composition of claim 1, wherein the first semiconductor material has the formula MₓO_{y}, where x is greater than zero, y is greater than zero, and M is selected from the group consisting of titanium, zirconium, zinc, tungsten, niobium, lanthanum, tantalum, terbium and tin.

6. The composition of claim 5, wherein the first semiconductor material comprises titania.

7. The composition of claim 1, wherein the second semiconductor material has the formula MₓO_{y}, where x is greater than zero, y is greater than zero, and M is selected from the group consisting of titanium, zirconium, zinc, tungsten, niobium, lanthanum, tantalum, terbium and tin.

8. The composition of claim 7, wherein the second semiconductor material comprises titania.

9. The composition of claim 1, further comprising a photosensitizing agent.

10. The composition of claim 9, wherein the photosensitizing agent is selected from the group consisting of anthocyanines, porphyrins, phthalocyanines, merocyanines, cyanines, squarates, eosins, and metal-containing dyes.

11. The composition of claim 9, wherein the composition is a photoactive layer capable of being used in a photovoltaic cell.

12. The composition of claim 1, wherein less than about 25% of a total surface area of the macroparticles is exposed.

13. The composition of claim 1, wherein at least about 70% of a total surface area of the macroparticles has nanoparticles chemically bonded thereto.

14. The composition of claim 1, wherein the macroparticles have an average particle size of at least about 125 nanometers.

15. The composition of claim 14, wherein the nanoparticles have an average particle size of at most about 40 nanometers.

16. The composition of claim 1, wherein the nanoparticles have an average particle size of at most about 40 nanometers.

17. A photovoltaic cell, comprising:
a first electrode;
a second electrode; and
a photoactive layer between the first and second electrodes, the photoactive layer is based on the composition of claim 1.

18. The photovoltaic cell of claim 17, wherein the composition further includes a photosensitizing agent.

19. A method of making the composition of claim 1, comprising:
forming a first mixture comprising a precursor of semiconductor nanoparticles;
forming a second mixture comprising semiconductor macroparticles having an average particles size of at least about 100 nanometers; and
combining the first and second mixtures.

20. The method of claim 19, further comprising reacting the precursor and semiconductor nanoparticles.

21. The method of claim 20, wherein reacting includes, after combining the first and second mixtures, heating the precursor and semiconductor particles.

22. The method of claim 21, further comprising, before heating precursor and semiconductor particles, adding an acid to the precursor and semiconductor particle to form a third mixture.

23. The method of claim 22, wherein the acid is selected from the group consisting of nitric acid, sulfuric acid and hydrochloric acid.

24. The method of claim 23, wherein the acid comprises nitric acid.

25. The method of claim 22, further comprising, after adding the acid, heating the third mixture to a first temperature.

26. The method of claim 25, wherein the first temperature is at most about 100°C.

27. The method of claim 25, further comprising:
holding the third mixture at the first temperature for a period of time; and
then, heating the third mixture to a second temperature higher than the first temperature.

28. The method of claim 27, wherein the second temperature is at least about 200°C.

29. A method of making the composition of claim 1 comprising:
combining a precursor of semiconductor nanoparticles and semiconductor macroparticles; and
reacting the precursor and macroparticles,
wherein the macroparticles have an average particles size of at least about 100 nanometers.

30. The method of claim 29, wherein reacting the precursor and macroparticles forms a composition comprising semiconductor nanoparticles and semiconductor macroparticles, at least some of the nanoparticles and macroparticles being chemically bonded to each other, and the semiconductor nanoparticles having an average particle size of at most about 50 nanometers.

31. The method of claim 30, further comprising treating the composition with a photosensitizing agent to form a photoactive layer.

32. The method of claim 31, further comprising incorporating the photoactive layer into a photovoltaic cell.

## Patentansprüche

1. Zusammensetzung für fotoaktive Schichten in fotovoltaischen Zellen, aufweisend:
Makroteilchen eines ersten Halbleitermaterials, wobei die Makroteilchen eine durchschnittliche Teilchengröße von mindestens ungefähr 100 Nanometer aufweisen; und
Nanoteilchen eines zweiten Halbleitermaterials, wobei die Nanoteilchen eine durchschnittliche Größe von mindestens ungefähr 50 Nanometer aufweisen,
wobei mindestens einige der Nanoteilchen und Makroteilchen chemisch miteinander gebunden sind.

2. Zusammensetzung nach Anspruch 1, bei welcher das erste und das zweite Halbleitermaterial das gleiche ist.

3. Zusammensetzung nach Anspruch 2, bei welcher das erste Halbleitermaterial die Formel MₓO_{y} hat, wobei x größer als Null ist, y größer als Null ist und M ausgewählt ist aus der Gruppe bestehend aus Titan, Zirkonium, Zink, Wolfram, Niob, Lanthan, Tantal, Terbium und Zinn.

4. Zusammensetzung nach Anspruch 3, bei welcher das erste Halbleitermaterial Titandioxid aufweist.

5. Zusammensetzung nach Anspruch 1, bei welcher das erste Halbleitermaterial die Formel MₓO_{y} hat, wobei x größer als Null ist, y größer als Null ist und M ausgewählt ist aus der Gruppe bestehend aus Titan, Zirkonium, Zink, Wolfram, Niob, Lanthan, Tantal, Terbium und Zinn.

6. Zusammensetzung nach Anspruch 5, bei welcher das erste Halbleitermaterial Titandioxid aufweist.

7. Zusammensetzung nach Anspruch 1, bei welcher das zweite Halbleitermaterial die Formel MₓO_{y} hat, wobei x größer als Null ist, y größer als Null ist und M ausgewählt ist aus der Gruppe bestehend aus Titan, Zirkonium, Zink, Wolfram, Niob, Lanthan, Tantal, Terbium und Zinn.

8. Zusammensetzung nach Anspruch 7, bei welcher das zweite Halbleitermaterial Titandioxid aufweist.

9. Zusammensetzung nach Anspruch 1, weiter aufweisend ein lichtempfindliches Agens.

10. Zusammensetzung nach Anspruch 9, bei welcher das lichtempfindliche Agens ausgewählt ist aus der Gruppe bestehend aus Anthocyaniden, Porphyrinen, Phthalocyaninen, Merocyaninen, Cyaninen, Salzen der Quadratsäure, Eosinen und Metall enthaltenden Farbstoffen.

11. Zusammensetzung nach Anspruch 9, bei welcher die Zusammensetzung eine fotoaktive Schicht ist, welche in einer fotovoltaischen Zelle benutzbar ist.

12. Zusammensetzung nach Anspruch 1, bei welcher weniger als ungefähr 25% eines gesamten Oberflächenbereichs der Makroteilchen exponiert ist.

13. Zusammensetzung nach Anspruch 1, bei welcher mindestens ungefähr 70% eines gesamten Oberflächenbereichs der Makroteilchen chemisch an diese gebundene Nanoteilchen hat.

14. Zusammensetzung nach Anspruch 1, bei welcher die Makroteilchen eine durchschnittliche Teilchengröße von mindestens ungefähr 125 Nanometer haben.

15. Zusammensetzung nach Anspruch 14, bei welcher die Nanoteilchen eine durchschnittliche Teilchengröße von mindestens ungefähr 40 Nanometer haben.

16. Zusammensetzung nach Anspruch 1, bei welcher die Nanoteilchen eine durchschnittliche Teilchengröße von mindestens ungefähr 40 Nanometer haben.

17. Fotovoltaische Zelle, aufweisend:
eine erste Elektrode;
eine zweite Elektrode; und
eine fotoaktive Schicht zwischen der ersten und zweiten Elektrode, wobei die fotoaktive Schicht auf der Zusammensetzung des Anspruchs 1 beruht.

18. Fotovoltaische Zelle nach Anspruch 17, bei welcher die Zusammensetzung weiter ein lichtempfindliches Agens aufweist.

19. Verfahren zum Herstellen der Zusammensetzung nach Anspruch 1, aufweisend:
Bilden einer ersten Mischung aus einem Vorläufer von Halbleiter-Nanoteilchen;
Bilden einer zweiten Mischung aus Halbleiter-Makroteilchen mit einer durchschnittlichen Teilchengröße von mindestens ungefähr 100 Nanometern; und
Kombinieren der ersten und zweiten Mischung.

20. Verfahren nach Anspruch 19, weiter aufweisend Reagierenlassen des Vorläufers und der Halbleiter-Nanoteilchen.

21. Verfahren nach Anspruch 20, bei welchem das Reagierenlassen das Erhitzen des Vorläufers und der Halbleiterteilchen nach dem Kombinieren der ersten und zweiten Mischung aufweist.

22. Verfahren nach Anspruch 21, weiter aufweisend vor dem Erhitzen des Vorläufers und der Halbleiterteilchen das Hinzufügen einer Säure zu dem Vorläufer und den Halbleiterteilchen, um eine dritte Mischung zu bilden.

23. Verfahren nach Anspruch 21, bei welchem die Säure ausgewählt wird aus der Gruppe bestehend aus Salpetersäure, Schwefelsäure und Salzsäure.

24. Verfahren nach Anspruch 23, bei welchem die Säure Salpetersäure aufweist.

25. Verfahren nach Anspruch 22, weiter aufweisend nach dem Hinzufügen der Säure das Erhitzen der dritten Mischung auf eine erste Temperatur.

26. Verfahren nach Anspruch 25, bei welchem die erste Temperatur höchstens ungefähr 100° C ist.

27. Verfahren nach Anspruch 25, weiter aufweisend:
Halten der dritten Mischung bei der ersten Temperatur für einen Zeitabschnitt; und
dann Erhitzen der dritten Mischung auf eine zweite Temperatur größer als die erste Temperatur.

28. Verfahren nach Anspruch 27, bei welchem die zweite Temperatur mindestens ungefähr 200° C ist.

29. Verfahren zum Herstellen der Zusammensetzung nach Anspruch 1, aufweisend:
Kombinieren eines Vorläufers von Halbleiter-Nanoteilchen und Halbleiter-Makroteilchen; und
Reagierenlassen des Vorläufers und der Makroteilchen,
wobei die Makroteilchen eine durchschnittliche Teilchengröße von mindestens ungefähr 100 Nanometern haben.

30. Verfahren nach Anspruch 29, bei welchem das Reagierenlassen des Vorläufers und der Makroteilchen eine Zusammensetzung bildet, aufweisend Halbleiter-Nanoteilchen und Halbleiter-Makroteilchen, wobei mindestens einige der Nanoteilchen und der Makroteilchen chemisch miteinander gebunden sind und die Halbleiter-Nanoteilchen eine durchschnittliche Teilchengröße von höchstens ungefähr 50 Nanometer haben.

31. Verfahren nach Anspruch 30, weiter aufweisend das Behandeln der Zusammensetzung mit einem lichtempfindlichen Agens, um eine fotoaktive Schicht zu bilden.

32. Verfahren nach Anspruch 31, weiter aufweisend das Integrieren der fotoaktiven Schicht in eine fotovoltaische Zelle.

## Revendications

1. Composition pour des couches photoactives dans des cellules photovoltaïques, comprenant :
des macroparticules d'un premier matériau semi-conducteur, les macroparticules ayant une dimension de particule moyenne d'au moins environ 100 nanomètres et
des nanoparticules d'un deuxième matériau semi-conducteur, les nanoparticules ayant une dimension moyenne au plus d'environ 50 nanomètres,
dans laquelle au moins certaines des nanoparticules et des macroparticules sont liées chimiquement les unes aux autres.

2. Composition selon la revendication 1, dans laquelle les premier et deuxième matériaux semi-conducteurs sont les mêmes.

3. Composition selon la revendication 2, dans laquelle le premier matériau semi-conducteur répond à la formule MₓO_{y}, dans laquelle x est supérieur à zéro, y est supérieur à zéro et M est choisi dans le groupe comprenant le titane, le zirconium, le zinc, le tungstène, le niobium, le lanthane, le tantale, le terbium et l'étain.

4. Composition selon la revendication 3, dans laquelle le premier matériau semi-conducteur comprend de l'oxyde de titane.

5. Composition selon la revendication 1, dans laquelle le premier matériau semi-conducteur répond à la formule MₓO_{y}, dans laquelle x est supérieur à zéro, y est supérieur à zéro et M est choisi dans le groupe comprenant le titane, le zirconium, le zinc, le tungstène, le niobium, le lanthane, le tantale, le terbium et l'étain.

6. Composition selon la revendication 5, dans laquelle le premier matériau semi-conducteur comprend de l'oxyde de titane.

7. Composition selon la revendication 1, dans laquelle le deuxième matériau semi-conducteur répond à la formule MₓO_{y}, dans laquelle x est supérieur à zéro, y est supérieur à zéro et M est choisi dans le groupe comprenant le titane, le zirconium, le zinc, le tungstène, le niobium, le lanthane, le tantale, le terbium et l'étain.

8. Composition selon la revendication 7, dans laquelle le deuxième matériau semi-conducteur comprend de l'oxyde de titane.

9. Composition selon la revendication 1, comprenant, en outre, un agent photosensibilisant.

10. Composition selon la revendication 9, dans laquelle l'agent photosensibilisant est choisi dans le groupe comprenant les anthocyanines, les porphyrines, les phtalocyanines, les mérocyanines, les cyanines, les squarates, les éosines et les colorants renfermant du métal.

11. Composition selon la revendication 9, dans laquelle la composition est une couche photoactive capable d'être utilisée dans une cellule photovoltaïque.

12. Composition selon la revendication 1, dans laquelle moins d'environ 25 % d'une étendue de surface totale des macroparticules est exposé.

13. Composition selon la revendication 1, dans laquelle au moins environ 70 % d'une étendue de surface totale des macroparticules a des nanoparticules reliées chimiquement à celles-ci.

14. Composition selon la revendication 1, dans laquelle les macroparticules ont une dimension de particule moyenne d'au moins environ 125 nanomètres.

15. Composition selon la revendication 14, dans laquelle les nanoparticules ont une dimension de particule moyenne au plus d'environ 40 nanomètres.

16. Composition selon la revendication 1, dans laquelle les nanoparticules ont une dimension de particule moyenne au plus d'environ 40 nanomètres.

17. Cellule photovoltaïque comprenant :
une première électrode ;
une deuxième électrode et
une couche photoactive entre les première et deuxième électrodes, la couche photoactive est basée sur la composition de la revendication 1.

18. Cellule Photovoltaïque selon la revendication 17, dans laquelle la composition comprend, en outre, un agent photosensibilisant.

19. Procédé d'obtention de la composition selon la revendication 1, comprenant ;
la formation d'un premier mélange comprenant un précurseur de nanoparticules de semi-conducteur ;
la formation d'un deuxième mélange comprenant des macroparticules de semi-conducteur ayant une dimension de particule moyenne d'au moins environ 100 nanomètres et
la combinaison des premier et deuxième mélanges.

20. Procédé selon la revendication 19, comprenant, en outre, la réaction du précurseur et des nanoparticules de semi-conducteur.

21. Procédé selon la revendication 20, dans lequel la réaction comprend, après la combinaison des premier et deuxième mélanges, le chauffage du précurseur et des particules de semi-conducteur.

22. Procédé selon la revendication 21, comprenant, en outre, avant le chauffage du précurseur et des particules de semi-conducteur, l'addition d'un acide au précurseur et aux particules de semi-conducteur pour former un troisième mélange.

23. Procédé selon la revendication 22, dans lequel l'acide est choisi dans le groupe comprenant l'acide nitrique, l'acide sulfurique et l'acide chlorhydrique.

24. Procédé selon la revendication 23, dans lequel l'acide comprend l'acide nitrique.

25. Procédé selon la revendication 22, comprenant, en outre, après l'addition de l'acide, le chauffage du troisième mélange à une première température.

26. Procédé selon la revendication 25, dans lequel la première température est au plus d'environ 100°C.

27. Procédé selon la revendication 25, comprenant, en outre :
le maintien du troisième mélange à la première température pendant une période de temps et
ensuite le chauffage du troisième mélange à une deuxième température supérieure à la première température.

28. Procédé selon la revendication 27, dans lequel la deuxième température est au moins d'environ 200°C.

29. Procédé d'obtention de la composition selon la revendication 1, comprenant :
la combinaison d'un précurseur de nanoparticules de semi-conducteur et de macroparticules de semi-conducteur et
la réaction du précurseur et des macroparticules,
dans lequel les macroparticules ont une dimension de particule moyenne d'au moins environ 100 nanomètres.

30. Procédé selon la revendication 29, dans lequel la réaction du précurseur et des macroparticules forme une composition comprenant des nanoparticules de semi-conducteur et des macroparticules de semi-conducteur, au moins certaines des nanoparticules et des macroparticules étant reliées chimiquement les unes aux autres et les nanoparticules de semi-conducteur ayant une dimension de particule moyenne au plus d'environ 50 nanomètres.

31. Procédé selon la revendication 30, comprenant, en outre, le traitement de la composition avec un agent photosensibilisant pour former une couche photoactive.

32. Procédé selon la revendication 31, comprenant, en outre, l'incorporation de la couche photoactive dans une cellule photovoltaïque.
